Europäisches Patentamt

European Patent Office

Office européen des brevets

(11) Veröffentlichungsnummer : **0 101 085**
**B1**

(12) **EUROPÄISCHE PATENTSCHRIFT**

(45) Veröffentlichungstag der Patentschrift :
07.05.86

(21) Anmeldenummer : **83108013.0**

(22) Anmeldetag : **12.08.83**

(51) Int. Cl.⁴ : **H 03 K 19/003**, H 03 K 19/086

(54) Integriertes Verknüpfungsglied in E2-CL-Technik.

(30) Priorität : **17.08.82 DE 3230591**

(43) Veröffentlichungstag der Anmeldung :
**22.02.84 Patentblatt 84/08**

(45) Bekanntmachung des Hinweises auf die Patenterteilung : **07.05.86 Patentblatt 86/19**

(84) Benannte Vertragsstaaten :
**AT DE FR GB IT NL**

(56) Entgegenhaltungen :
**DER FERNMELDE-INGENIEUR, Band 27, Nr. 7, Juli 1973, Bad Windsheim, G. HANKE "ECL - Die Emittergekoppelte Logik", Seite 21**

(73) Patentinhaber : **Siemens Aktiengesellschaft**
**Berlin und München Wittelsbacherplatz 2**
**D-8000 München 2 (DE)**

(72) Erfinder : **Barré, Claude, Dipl.-Ing.**
**Implerstrasse 23**
**D-8000 München 70 (DE)**

**Beschreibung**

Die Erfindung bezieht sich auf ein Verknüpfungsglied nach dem Oberbegriff des Patentanspruchs 1.

Das Grundelement von Verknüpfungsgliedern in E²CL-Technik ist bekanntlich ein Differenzverstärker mit zwei Transistoren, deren Emitter verbunden sind. Am Verbindungspunkt der Emitter wird ein konstanter Strom eingespeist. Die Basis des einen Transistors liegt an einem festen Referenzpotential, die Basis des anderen Transistors ist an den Emitter eines als Emitterfolger geschalteten, durch ein Eingangssignal gesteuerten Transistors angeschlossen. Grundsätzlich ist jedem Transistor des Differenzverstärkers ein Kollektorarbeitswiderstand zugeordnet.

An den Kollektoren sind zwei komplementäre Ausgangssignale abgreifbar. Wird nur ein Ausgangssignal benötigt, dann kann der Kollektorwiderstand des Transistors, an dem kein Ausgangssignal abgenommen wird, entfallen. Der Kollektor dieses Transistors wird unmittelbar mit dem Anschluß für die Kollektorseitige Stromversorgung verbunden.

Integrierte Bausteine werden vor ihrem Einsatz in größeren Schaltungskomplexen überprüft, da die nachträgliche Lokalisierung fehlerhafter Bausteine und auch ihre Auswechslung häufig sehr mühsam und zeitraubend ist. Die Prüfung der integrierten Bausteine zur Ausscheidung mangelhafter Exemplare erfolgt durch das Anlegen von Bitmustern und, soweit erforderlich, von Taktsignalen an die Eingangsanschlüsse und durch die Beobachtung der sich ergebenden Ausgangssignale. Rein dynamische Messungen, wie die Messung von Signallaufzeiten und Störabständen werden nicht durchgeführt. Es können jedoch interne Schaltungsfehler vorliegen, die bei einer derartigen Prüfung im allgemeinen nicht erkennbar sind, aber beispielsweise die Störsicherheit verringern oder die Signallaufzeit erhöhen und damit beim Einsatz in einem System zu Ausfällen führen.

Ein solcher, meistens nicht erkennbarer Fehler in Schaltungsanordnungen der E²CL-Technik liegt vor, wenn der Kollektor desjenigen Transistors im Differenzverstärker, an dem kein Ausgangssignal abgenommen wird, aufgrund eines Fertigungsfehlers nicht angeschlossen ist.

Der Erfindung liegt die Aufgabe zugrunde, ein Verknüpfungsglied in E²CL-Technik so auszubilden, daß ohne Veränderung der normalen Funktion der genannte Fehler bei einer routinemäßigen Bausteinprüfung mit Sicherheit erkannt wird. Gemäß der Erfindung wird diese Aufgabe durch das kennzeichnende Merkmal des Patentanspruchs 1 gelöst.

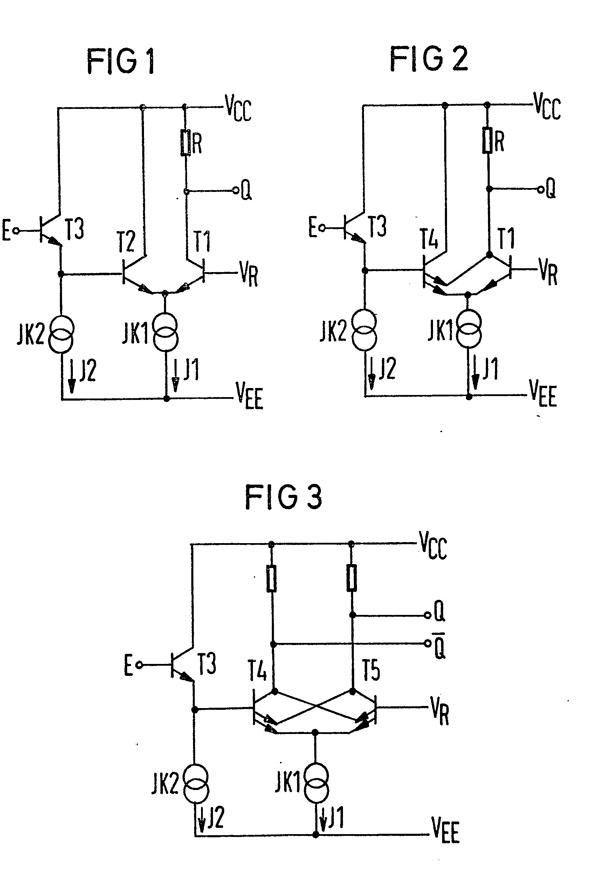

Die Erfindung wird anhand von Ausführungsbeispielen, die in den Figuren 2 und 3 der Zeichnung dargestellt sind, näher beschrieben. Die Figur 1 zeigt ein bekanntes Verknüpfungsglied, auf das zum besseren Verständnis der Erfindung zunächst nochmals eingegangen wird.

Das Verknüpfungsglied nach Figur 1 enthält einen Differenzverstärker mit den Transistoren T1 und T2. Eine Stromquelle IK1 speist in den Verbindungspunkt der beiden Emitter einen konstanten Strom I1 ein. Die Basis des Transistors T1 liegt an einem festen Referenzpotential $V_R$. Die Basis des Transistors T2 ist mit dem Emitter eines als Emitterfolger betriebenen Transistors T3 verbunden. Eine Stromquelle IK2 versorgt den Emitterfolger mit einem konstanten Strom I2. An der Basis des Transistors T3 liegt ein Eingangssignal E. Ein Ausgangssignal Q = E wird nur am Kollektor des Transistors T1 abgenommen. Es ist daher ein Kollektorwiderstand R vorgesehen. Auf einen Kollektorwiderstand für den Transistor T2 kann verzichtet werden.

Als Fehlerfall sei angenommen, daß die notwendige Verbindung des Kollektors des Transistors T2 mit dem Anschluß $V_{CC}$ der Versorgungsspannung nicht existiert. Bei E = L (niederer binärer Signalpegel) arbeitet das Verknüpfungsglied normal, da der Transistor T2 ohnehin gesperrt ist. Ist dagegen E = H (hoher binärer Signalpegel), dann fließt der gesamte Strom I1 durch den Transistor T3 (hier zusätzlich zum Strom (I2) und über die Basis-Emitter-Diode des Transistors T2. Der Transistor T1 wird wie im Normalfall gesperrt. Da aber der Spannungsabfall an der Basis-Emitter-Diode von dem Spannungsabfall an der Kollektor-Emitter-Strecke abweicht, wird die Schaltschwelle verschoben, was die Störsicherheit negativ beeinflußt. Außerdem verlängert sich die Signallaufzeit, weil der Transistor T2 gesättigt ist.

Die Figur 2 zeigt ein erfindungsgemäßes Verknüpfungsglied, das weitgehend der bekannten Schaltungsanordnung gleicht. Abweichend davon ist jedoch an die Stelle des Transistors T2 ein Transistor T4 mit zwei Emittern getreten. Der zweite Emitter ist mit dem Kollektor des Transistors T1 verbunden. Unterstellt man wieder, daß der Kollektor des Transistors T4 nicht angeschlossen ist, dann fließt beim hohen Signalpegel E = H am Eingang ein Strom über den zweiten Emitter (der sozusagen die Rolle des eigentlichen, aber nicht angeschlossenen Kollektors übernimmt) und über den Kollektorwiderstand R des Transistors E1. Am Kollektorwiderstand R entsteht ein Spannungsabfall, so daß sich am Ausgang Q ein Pegel einstellt, der wenigstens annähernd dem tiefen binären Signalpegel entspricht. Damit ist der angenommene Fehler mit Sicherheit erkennbar, weil bei einer fehlerfreien Schaltungsanordnung unter den gegebenen Voraussetzungen am Ausgang Q der hohe binäre Signalpegel anliegen müßte.

Die Anwendung der Schaltungsmaßnahme gemäß der Erfindung ist auch dann zweckmäßig, wenn allein der invertierende Ausgang $\bar{Q}$ benutzt wird. Wenn nämlich die Verbindung zum Kollektor des Transistors T1 (Figur 1) fehlt, steigt zwar die Strombelastung der Referenzspannungsquelle erheblich, doch ist diese im allgemeinen für eine Vielzahl von Schaltelementen in einem integrierten Baustein gemeinsam vorgesehen und daher mindestens soweit belastbar, daß sich das Referenzpotential $V_R$ um weniger als den halben Signalhub verändert. In diesem Fall muß der Transistor T1 mit einem zweiten Emitter ausgestattet sein, der mit dem Kollektor des Transistors T2 verbunden ist. Der erkennbar falsche Signalpegel am Ausgang $\bar{Q}$ entsteht bei einem Eingangspegel E = L.

Die Figur 3 zeigt ein Ausführungsbeispiel der Erfindung, das vorzugsweise dann eingesetzt wird, wenn nur einer der Ausgänge Q oder $\bar{Q}$ benützt wird, aber bei der Schaltungsauslegung noch nicht feststeht, welcher der beiden infrage kommt (programmierbare Schaltungsanordnungen). Wie aus der Darstellung ersichtlich ist, weisen beide Transistoren T4 und T5 des Differenzverstärkers zusätzliche Emitter auf, die kreuzweise mit den Kollektoren der jeweils anderen Transistoren verbunden sind.

Die erfindungsgemäßen Schaltungsmaßnahmen können auch bei Verknüpfungsgliedern mit Serienkopplung (Series Gating) oder Kollektorkopplung (Collector Dotting) verwendet werden.

### Patentansprüche

1. Integriertes Verknüpfungsglied in E²CL-Technik mit einem Differenzverstärker aus zwei emittergekoppelten Transistoren (T1, T4) mit emitterseitiger Konstantstromeinspeisung (JK1), mit mindestens einem Eingangsemitterfolger, dadurch gekennzeichnet, daß mindestens derjenige Transistor (z. B. T4) der beiden Transistoren (T1, T4) des Differenzverstärkers, an dem kein Ausgangssignal abgenommen wird, einen zweiten Emitter besitzt, der mit dem Kollektor des anderen Transistors (z. B. T1) verbunden ist.

2. Verknüpfungsglied nach Anspruch 1, dadurch gekennzeichnet, daß beide Transistoren (T4, T5) des Differenzverstärkers zweite Emitter besitzen, und daß jeweils der zweite Emitter des einen Transistors mit dem Kollektor des anderen Transistors kreuzweise verbunden ist.

### Claims

1. An integrated logic-linking element in E²CL-technology comprising a differential amplifier which consists of two emitter-coupled transistors (T1, T4) with a constant current (JK1) fed in on the emitter side and with at least one input emitter follower, characterised in that at least that transistor (e. g. T4) of the two transistors (T1, T4) of the differential amplifier from which no output current is obtained has a second emitter connected to the collector of the other transistor (e. g. T1).

2. A logic-linking element as claimed in Claim 1, characterised in that both transistors (T4, T5) of the differential amplifier have second emitters and that in each case the second emitter of the first transistor is cross-connected to the collector of the other transistor.

### Revendications

1. Elément logique intégré selon la technique E²CL, comportant un amplificateur différentiel formé de deux transistors (T1, T4) couplés par leurs émetteurs et comportant une alimentation en courant constant (JK1), située du côté émetteur, et comportant au moins un étage d'entrée monté en émetteur suiveur, caractérisé par le fait qu'au moins celui (par exemple T4) des deux transistors (T1, T4) de l'amplificateur différentiel, sur lequel aucun signal de sortie n'est prélevé, comporte un second émetteur qui est relié au collecteur de l'autre transistor (par exemple T1).

2. Elément logique suivant la revendication 1, caractérisé par le fait que les deux transistors (T4, T5) de l'amplificateur différentiel possèdent des seconds émetteurs et que respectivement le second émetteur d'un transistor est relié, selon un montage croisé, au collecteur de l'autre transistor.

# FIG 1

# FIG 2

# FIG 3